# EUROPÄISCHE PATENTANMELDUNG

(11) **EP 0 688 155 A1**
(43) Veröffentlichungstag der Anmeldung: **20.12.1995**
(21) Anmeldenummer: 95108553.9
(22) Anmeldetag: 03.06.1995
(51) Int. Cl.: H05K 3/32, F21V 19/00, H01L 33/00

(54) **Adapter zur elektrischen Verbindung von optoelektronischen Bauelementen mit einer Leiterplatte**

(30) Priorität: 14.06.1994 DE 4420698
(71) Anmelder: Rudolf Schadow GmbH, D-13509 Berlin (DE)
(72) Erfinder: Heeb, Alfred, D-13509 Berlin (DE); Wisskirchen, Klaus, D-13465 Berlin (DE)
(74) Vertreter: Dreiss, Fuhlendorf & Steimle Patentanwälte

(57) **Zusammenfassung**

Ein Adapter (1) zur elektrischen Verbindung eines optoelektronischen Bauelements (2) mit einer Leiterplatte (8) weist einen Sockel (3,103,203) auf, der mit zwei Kanälen (4) für Anschlußdrähte (7) des optoelektronischen Bauelements (2) versehen und mit SMD-Anschlußkontakten (6) zur elektrischen Verbindung mit der Leiterplatte (8) bestückt ist. Mit einem derartigen Adapter (1) sind gewünschte Postionierungshöhen optoelektronischer Bauelemente (2) über der Leiterplatte (8) in einfacher Weise erreichbar; außerdem ist der Adapter (1) im Zusammenhang mit der SMD-Technik verwendbar.

## Beschreibung

Die vorliegende Erfindung bezieht sich auf einen Adapter zur elektrischen Verbindung eines optoelektronischen Bauelements mit einer Leiterplatte nach dem Oberbegriff des Anspruchs 1.

Bei der Bestückung von Leiterplatten mit elektronischen Bauelementen sind zwei Montagetechniken bekannt:
Bei der konventionellen Printtechnik werden beim Layout Lochmasken erstellt. Diese sind erforderlich, um die Bohrungen für die Anschlußdrähte der Bauelemente an den richtigen Stellen auf der Leiterplatte anbringen zu können.

Die bei dieser Technik verwendeten Bauelemente sind mit mindestens zwei Anschlußdrähten versehen, die in die Bohrungen der Leiterplatte gesteckt und dort angelötet werden. Mit Hilfe dieser Bohrungen werden also die elektronischen Bauelemente auf der Leiterplatte sowohl mechanisch als auch elektrisch leitend mit den Leiterbahnen verbunden.

Im Gegensatz zur konventionellen Printtechnik hat sich in den letzten Jahren die Oberflächenmontagetechnik durchgesetzt. Diese wird auch als SMD-Technik (Surface Mounted Device) bezeichnet. Bei dieser Montagetechnik liegen die Bauteile mit ihren SMD-Anschlußkontakten flach auf der Leiterplatte. Die Bauelemente werden auf der Bestückungsseite verlötet, so daß Bohrlöcher, wie sie für die konventionelle Printmontage erforderlich sind, entfallen. Dadurch ist es auch möglich die Platinen beidseitig zu bestücken. Oft wird auch eine Mischbestückung aus Bohr- und Oberflächenmontage angewandt, weil zum einen einige Bauteile noch nicht als SMD-Baugruppen verfügbar sind, zum anderen eine SMD-Bauform aus anderen Gründen, z.B. Kostengründen nicht in Frage kommt. Ein sehr wichtiger Aspekt für den Einsatz der SMD-Technik ist, daß Anschlußdrähte im Bereich der Hochspannungs- und Hochfrequenztechnik wegen der elektromagnetischen Verträglichkeit (EMV) prinzipiell vermieden werden müssen. Zwar ist die Miniaturisierung der Baugruppen das auffallendste Merkmal der SMD-Technik, jedoch wird auch eine höhere Zuverlässigkeit der Bauelemente erreicht. Zusätzlich entstehen bezüglich der Lötverfahren entscheidende Vorteile. Durch maschinelles Wellenlöten, Dampfphasen-, Reflow- und Infrarotlöten wird die Wirtschaftlichkeit bei den Verbindungs- und Montageprozessen stark erhöht.

Es sind nun optoelektronische Bauelemente, z.B. Leuchtdioden (LED), in SMD-Technik bekannt. Diese weisen gegenüber herkömmlichen Leuchtdioden zwei Merkmale auf. Einerseits muß das Kunststoffmaterial, in dem der LED-Chip enthalten ist, gegenüber konventionellen Leuchtdioden eine höhere Temperaturbeständigkeit aufweisen. Andererseits muß auch die Kontaktanordnung der SMD-Leuchtdiode SMD-fähig sein. Dies ist wichtig, da SMD-Bauelemente meist maschinell verlötet werden. Dabei werden die SMD-Bauelemente zuerst auf der Leiterplatte fixiert und dann durch einen entsprechenden Lötofen geschickt, in dem die Platine mit allen Bauteilen hohen Temperaturen ausgesetzt.

Wegen der starken Miniaturisierung und den fehlenden Drahtkontakten tritt aber auch das Problem auf, daß z.B. bei Aktuatoren und Sensoren, wie z.B. Leuchtdioden, die Montageposition unmittelbar oberhalb der Platinenoberfläche ungeeignet für den Einsatz des Bauelements ist. SMD-Leuchtdioden sind aufgrund ihres gedrungenen Aufbaus direkt auf der Leiterplatte positioniert, so daß die Strahlungsquelle nur wenige mm über der Leiterplatte liegt. Diese wird jedoch allgemein in einigem Abstand von der Leiterplatte benötigt. Dasselbe gilt auch für andere Sensoren oder Aktuatoren wie Meßvorrichtungen, elektrotechnische Kleinstmotoren u.ä.

Ein Adapter der eingangs genannten Art ist aus der US-A-4 837 927 bekannt geworden. Bei diesem bekannten Adapter sind innerhalb der Kanäle Federsteckverbindungselemente angeordnet, die an einer Seite Anschlußdrähte von optoelektronischen Bauelementen steckend aufnehmen und die anderenends Verlängerungen zur Bildung der SMD-Anschlußkontakte versehen sind. Derartige Adapter sind konstruktiv und herstellungstechnisch aufwendig und ergeben keine feste Verbindung zwischen SMD-Anschlußkontakten und den Bauelementen.

In der US-A-5 116 229 und der DE-T2-690 03 724 sind Adapter beschrieben, die eine Leuchtdiode nach Art einer Fassung aufnehmen, wobei die Anschlußdrähte der Leuchtdioden durch den Adapter hindurchgeführt und am anderen Ende des Adapters herausgeführt sind, so daß die Leuchtdiode mit ihren Anschlußdrähten in konventioneller Printtechnik mit der Leiterplatte verbunden wird.

Beim Adapter sowohl nach der zuerst genannten Druckschrift als auch nach den zuletzt genannten beiden Druckschriften können optoelektronische Bauelemente nur dann verwendet werden, wenn sie in konventioneller Weise mit Anschlußdrähten, wie sie für die Printtechnik vorgesehen sind, versehen sind. Eine Verwendung von optoelektronischen Bauelementen, wie sie für die SMD-Technik Verwendung finden, können bei diesen bekannten Adaptern nicht eingesetzt werden. Der Adapter ist lediglich zwischen das optoelektronische Bauelement und die Leiterplatte geklemmt.

Aufgabe der vorliegenden Erfindung ist es deshalb, einen Adapter der eingangs genannten Art zu schaffen, der, obwohl er ausschließlich für die Verwendbarkeit bei der SMD-Verbindungstechnik aufgebaut ist, sowohl für den Einsatz von optoelektronischen Bauelementen mit Anschlußdrähten als auch für den Einsatz von für die SMD-Verbindungstechnik ausgerüsteten optoelektronischen Bauelementen geeignet ist.

Zur Lösung dieser Aufgabe sind erfindungsgemäß die im Anspruch 1 angegebenen Merkmale vorgesehen.

Auf diese Weise ist ein Adapter geschaffen, an dem, obwohl er selbst für die SMD-Verbindungstechnik geeignet ist, optoelektronische Bauelemente beider Gattungen also sowohl solcher mit herkömmlichen Anschlußdrähten als auch solcher, die für die SMD-Verbindungstechnik geeignet sind, verwendet werden können. Desweiteren ist der Adapter selbst unmittelbar an der Leiterplatte gehalten und kann über die SMD-Anschlußkontakte ausgerichtet werden. Der mindestens eine Kanal des Adapters ist so ausgestaltet, daß er die Anschlußdrähte von nicht SMD-fähigen LED aufnehmen oder daß in ihn Kontaktdrähte oder -schienen eingesetzt werden können, die den Kanal an der Oberseite überragen. An diesen Überstand kann dann eine SMD-fähige LED angelötet werden. Der Adapter kann auf einfache Weise wie andere SMD-Bauelemente auf der Leiterplatte fixiert und bspw. durch maschinelles Wellenlöten elektrisch leitend mit dieser verbunden werden kann. Der Adapter bzw. das optoelektronische Bauelement kann in den verschiedenen Ausführungsformen der SMD-Technik verwendet sein. Dazu gehören die Chip-Technik, bei der Adapter bzw. Bauelement quaderförmig aufgebaut sind, die MELF-Technik (Metal Electrode Face), bei der das Bauelement oder der Adapter im allgemeinen zylinderförmig ist, die SOT-Technik (Small Outline Transistor Package) und die SO-Technik (Small Outline).

Der Adapter eignet sich für alle Sensoren bzw. Aktuatoren, die im Bereich der Elektrotechnik ihren Einsatz finden. Es können auch andere Bauelemente, wie Schalter oder elektrische Kleinstmotoren über den Adapter in ihre Position gebracht werden und durch die SMD-Technik auf der Leiterplatte angelötet werden. Auch kann der Adapter selbst in jeder denkbaren Form gestaltet werden. Es kann bspw. vorgesehen sein, mehrere Adapter aneinander zu koppeln, so daß eine Bandanzeige für Leuchtdioden entstehen kann. Auch kann die Oberseite des Adapters eine von einer horizontalen Ebene abweichende Form aufweisen, um die optoelektronischen Bauelemente in entsprechende Positionen über der Leiterplatte zu bringen.

Der gewünschte Abstand der LED von der Platinenoberfläche wird durch die Höhe des Sockels des Adapters vorgegeben. Unterschiedliche Abstände können durch die Verwendung unterschiedlicher Adapter erzielt werden. Es sind aber auch Adapter denkbar, die auf die gewünschte Höhe ablängbar sind, z.B. durch Kürzen des Sockels, indem ein Teil an einer Sollbruchstelle abgebrochen wird.

Bei einer besonders vorteilhaften Weiterbildung der Erfindung kann der Adapter als Schalter- oder Tastergehäuse ausgeführt sein oder Bestandteil eines Schalter- oder Tastergehäuses sein, in dem die SMD-Anschlußkontakte integriert sind. Hierbei hat der Anwender den Vorteil, einen SMD-Schalter bzw. -Taster mit SMD-LED einsetzen zu können, bei der die Lötbedingungen für Schalter und LED gleich sind, da beide im Gehäuse des Adapters integriert sind. Durch den so hergestellten SMD-Schalter, können einerseits die Lochmasken beim Layout einer Leiterplatte eingespart werden und es können andererseits höhere Bauelement-Packungsdichten auf einer Leiterplatte realisiert werden.

Bei einer Ausführungsform des Adapters sind Aussparungen zum Auswechseln der Anschlußelemente und zur Erleichterung der Verbindungsherstellung zwischen Anschlußelementen und SMD-Anschlußkontakten vorgesehen.

Weist einer der Kanäle des Adapters an seiner dem Bauelement zugewandten Seite eine Erweiterung auf, ist der richtige Einbau einer mit einem Absatz versehenen Diode vom Adapter vereinfacht. Stattdessen oder gleichzeitig kann der Sockel an einer Seite eine vorzugsweise angeformte Nase aufweise. Falls richtungsabhängige Bauelemente verwendet werden, ermöglicht dies die "richtige" Bestückung von Dioden, falls deren Absatz vom Anschlußelement durch den Adapter verdeckt ist.

Weitere vorteilhafte Weiterbildungen der Erfindung sind in den weiteren Unteransprüchen definiert.

Im folgenden sind drei Ausführungsbeispiele unter Hinweis auf die beigefügten Zeichnungen näher beschrieben. Es stellen dar:
- Figur 1: einen Schnitt durch einen erfindungsgemäßen Adapter mit aufsitzendem optoelektronischem Bauelement mit herkömmlichen Drahtanschlüssen gemäß einem ersten Ausführungsbeispiel;
- Figur 2: einen Schnitt durch einen erfindungsgemäßen Adapter mit aufsitzendem optoelektronischem Bauelement in SMD-Anschlußtechnik gemäß einem zweiten Ausführungsbeispiel; und
- Figur 3: eine teilweise aufgebrochene perspektivische Ansicht eines erfindungsgemäßen Adapters in Form eines Schalters mit eingesetzter Leuchtdiode gemäß einem dritten Ausführungsbeispiel.

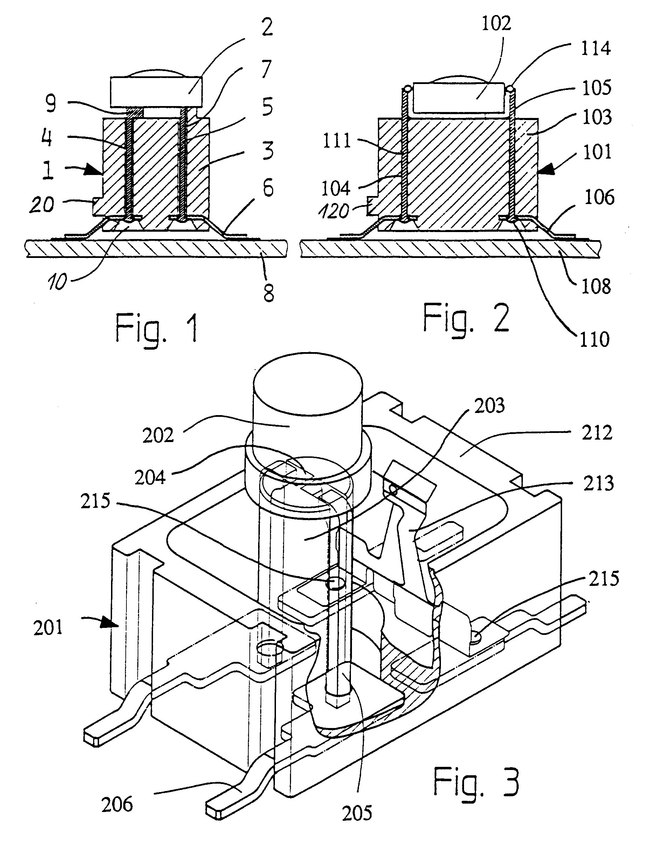

Figur 1 zeigt einen Adapter 1 zur elektrischen Verbindung von optoelektronischen Bauelementen 2, z.B. einer Leuchtdiode (LED), mit einer Leiterplatte 8. Der Adapter 1 weist einen bspw. zylindrischen Sockel 3 auf, der in Längserstreckung von zwei geschlossenen Kanälen 4 für Anschlußelemente 5 durchzogen ist. Die Anschlußelemente 5 sind sowohl mit dem optoelektronischen Bauelement 2 als auch mit SMD-Anschlußkontakten 6 des Adapters 1 elektrisch leitend verbunden. Die SMD-Anschlußkontakte sind nahe am der Leiterplatte 8 zugewandten Ende in den Sockel 3 eingebettet, reichen mit ihrem inneren Ende in den jeweiligen Kanal 4 und sind an ihrem freien äußeren Ende abgekröpft. Bei dem gezeigten ersten Ausführungsbeispiel sind die Anschlußelemente 5 in Form von Anschlußdrähten 7 Teil des optoelektronischen Bauelements 2. Die Anschlußdrähte 7 durchgreifen nach dem Aufsetzen des Bauelements 2 auf den Sockel 3 des Adapters 1 die Kanäle 4. Die Anschlußdrähte 7 werden zuvor so abgelängt, daß sie im Bereich der SMD-Anschlußkontakte 6 enden. Durch Aussparungen 10 an der Unterseite des Sockels 3 des Adapters 1 wird ermöglicht, daß das Anschlußelement 5 und der SMD-Anschlußkontakt 6 des Adapters 1 unlösbar elektrisch miteinander verbindbar sind. Dies kann z.B. durch Löten, Vernieten, Verschweißen, Laserverschweißen o.dgl. geschehen. Das optoelektronische Bauelement 2, das für die bei der SMD-Technik geforderten hohen Temperaturen geeignet ist, kann dann zusammen mit dem Adapter 1 wie ein Bauteil der SMD-Technik über die Anschlußkontakte 6 mit der Leiterplatte 8 verlötet werden. Die für einen bestimmten Anwendungszweck erforderliche Position und Höhe des optoelektronischen Bauelements 2 ist damit von der Längserstreckung des Adapters 1 vorgegeben. Leuchtdioden 2 sind teilweise an der Kathodenseite im Bereich der Anschlüsse durch einen Absatz 9 markiert, der eine Bestückung in der für die Funktion des optoelektronischen Bauelements 1 erforderlichen Lage ermöglicht. Dabei kann in nicht dargestellter Weise der Kanal 4 an der Oberseite des Adapters 1 so erweitert sein, daß der Absatz 9 eindringen kann. Zwischen der Leiterplatte 8 und der Unterseite des Sockels 3 besteht ebenfalls ein Zwischenraum, der ein nachträgliches Kippen des Adapters 1 nach dem Anlöten erlaubt, so daß das optoelektronische Bauelement 2, z.B. in der Ausführung als LED, exakt ausgerichtet werden kann, der Platz für einen Kleber vorsieht, mit dem die SMD-Bauteile vorfixiert werden. An einer Seite ist am Adapter 1 nahe dem betreffenden Anschlußkontakt 6 eine Nase 20 angeformt, die Verwendung richtungsabhängiger Bauelemente 2 erleichtert.

In Figur 2 ist ein zweites Ausführungsbeispiel eines Adapters 101 darstellt, der mit einem optoelektronischen Bauelement 102, z.B. einer LED bestückt ist, die bzw. das für die bei der SMD-Technik geforderten hohen Temperaturen geeignet ist und mit seitlichen elektrischen Anschlußpunkten 114 versehen ist. Der Adapter 101 weist ebenfalls einen bspw. zylindrischen Sockel 103 mit zwei geschlossenen Kanälen 104 für separate Anschlußelemente 105 und eine angeformte Nase 120 auf. In diesem Fall sind separate Anschlußelemente 105 in Form von Kontaktdrähten oder - schienen 111 vorgesehen, die in den Sockel 103 eingegossen sind. Die Kontaktdrähte 111 überragen die Oberseite des Sockels 103 und sind dort mit den Anschlußpunkten 114 des optoelektronischen Bauelements 102 z.B. durch Verlöten oder Verschweißen, elektrisch leitend verbunden. Die Anordnung von SMD-Anschlußkontakten 106 des Adapters 101 und deren elektrische Verbindung mit den inneren Enden der Kontaktdrähte 111 durch an der Unterseite des Sockels 103 vorhandene Aussparungen 110 ist entsprechend dem Ausführungsbeispiel der Figur 1 vorgesehen.

Figur 3 zeigt ein drittes Ausführungsbeispiel eines Adapters 201 in Form eines Gehäuses für einen Schalter oder Taster. Die schematische Ansicht zeigt ein Schaltergehäuseunterteil 212. In diesem Schaltergehäuseunterteil 212 befindet sich ein Sockel 203, auf den ein optoelektronisches Bauelement 202, z.B. eine temperaturbeständige Leuchtdiode (LED), aufgesetzt ist. Der Sockel 203 weist zwei einseitig offene Kanäle 204 auf, in denen Anschlußelemente 205 für das optoelektronische Bauelement 202 geführt sind. Die Anschlußelemente 208 sind einenends mit der LED 202 und andernends mit SMD-Anschlußkontakten 206 des Adapters 201 elektrisch leitend verbunden, die teilweise in das Gehäuseunterteil 212 eingebettet sind. Ein Schalterkontakt 213 ist im Schaltergehäuseunterteil 212 derart schwenkbar angeordnet, daß ein Umschalter, ein Taster oder ein Ein- bzw. Ausschalter entsteht. Dabei kann der Schalterkontakt 213 bspw. direkt über Nieten 215 auf das innere Ende des betreffenden SMD-Anschlußkontaktes 206 aufgenietet sein. Entsprechendes gilt in nicht dargestellter Weise für weitere Schalterkontakte und die Anschlußelemente 208. Dadurch, daß die Leuchtdiode 22 aufgrund des Sockels 203 in einer bestimmten Höhe fixiert ist, kann die Betätigungsfläche des Schalters optimal beleuchtet werden.

## Patentansprüche

1. Adapter zur elektrischen Verbindung eines optoelektronischen Bauelements (2,102,202) mit einer Leiterplatte (8,108), mit einem Sockel (3,103,203), der mit mindestens einem Kanal (4,104,204) für Anschlußelemente (5,105,205) versehen ist, und mit SMD-Anschlußkontakten (6,106,206) zur elektrischen Verbindung mit der Leiterplatte (8,108), **dadurch gekennzeichnet,** daß der Sockel (3,103,203) mit den SMD-Anschlußkontakten (6,106,206), die in den Bereich des Kanals (4,104,204) ragen, bestückt ist und entweder mit Anschlußelementen (5) in Form von Anschlußdrähten (7) des optoelektronischen Bauelements (2) oder mit Anschlußelementen (10,5,205) in Form von separaten Kontaktdrähten oder -schienen (111), deren jeweils anderes Ende mit SMD-Anschlußpunkten (114) des optoelektronischen Bauelementes (2,102,202) elektrisch verbunden ist, unlösbar verbunden, bspw. laserverschweißt sind.

2. Adapter nach Anspruch 1, dadurch gekennzeichnet, daß der Sockel (3,103,203) des Adapters (1,101) von seiner Unterseite ausgehende Aussparungen (10,110) aufweist, durch die die Verbindungsstellen der Anschlußelemente (5,105) an den SMD-Anschlußkontakten (6,106) zugänglich sind.

3. Adapter nach Anspruch 1 oder 2, gekennzeichnet, daß das optoelektronische Bauelement (2,102,202) über die Anschlußelemente (5,105,205) mechanisch am Adapter (1,101,201) befestigt ist.

4. Adapter nach einem der vorhergehenden Ansprüche, dadurch gekennzeichnet, daß der Kanal (204) als seitlich offener oder als geschlossener Kanal ausgebildet ist.

5. Adapter nach einem der vorhergehenden Ansprüche, dadurch gekennzeichnet, daß die Anschlußelemente (105) im Kanal (104) eingegossen oder von Kunststoff umspritzt sind.

6. Adapter nach einem der vorhergehenden Ansprüche, dadurch gekennzeichnet, daß der Adapter (201) durch zumindest einen Teil eines Schalter- oder Tastergehäuse (212) gebildet ist.

7. Adapter nach Anspruch 6, dadurch gekennzeichnet, daß das Schalter- oder Tastergehäuse (212) mit mehreren SMD-Anschlußkontakten (206) versehen ist.

8. Adapter nach einem der vorhergehenden Ansprüche, dadurch gekennzeichnet, daß der Adapter (1,101,201) aus SMD-fähigem, vorzugsweise für hohe Temperaturen geeigneten Material aufgebaut ist, in den die SMD-Anschlußkontakte (6,106,206) teilweise eingebettet sind.

9. Adapter nach einem der vorhergehenden Ansprüche, dadurch gekennzeichnet, daß einer der Kanäle (4) des Adapters (1) an seiner dem Bauelement (2) zugewandten Seite eine Erweiterung aufweist.

10. Adapter nach einem der vorhergehenden Ansprüche, dadurch gekennzeichnet, daß der Sockel (3; 103) an einer Seite eine vorzugsweise angeformte Nase (20; 120) aufweist.
